# EUROPÄISCHE PATENTSCHRIFT

(11) **EP 2 264 751 B1**
(45) Veröffentlichungstag und Bekanntmachung des Hinweises auf die Patenterteilung: **21.12.2011**
(21) Anmeldenummer: 09162702.6
(22) Anmeldetag: 15.06.2009
(51) Int. Cl.: H01L 21/74

(54) **SOI-Halbleiterprodukt mit oberseitigem Backgate-Anschluss und Verfahren zur Herstellung eines derartigen SOI-Halbleiterprodukts**
SOI semiconductor product with backgate connection on the upper side and method for producing same
Produit semi-conducteur SOI doté d'un raccordement de porte arrière côté supérieur et procédé de fabrication d'un tel produit semi-conducteur SOI

(43) Veröffentlichungstag der Anmeldung: 22.12.2010
(73) Patentinhaber: ELMOS Semiconductor AG, 44227 Dortmund (DE)
(72) Erfinder: Fischer, Stephan, 42389, Wuppertal (DE)
(74) Vertreter: von Kreisler Selting Werner

(56) Entgegenhaltungen:
- US-A- 5 610 083
- US-A1- 2002 094 666
- US-A1- 2009 057 746

## Beschreibung

Die Erfindung betrifft ein SOI-Halbleiterprodukt, das auf seiner Oberseite einen Backgate-Anschluss zur elektrischen Kontaktierung des unterseitigen Halbleitersubstrats aufweist. Ferner betrifft die Erfindung ein Verfahren zur Herstellung eines oberseitigen Backgate-Anschlusses bei einem SOI-Produkt.

Bei SOI-Produkten handelt es sich um Halbleiter-Produkte, die ein SOI-(Silicon-on-Oxid-)Substrat aufweisen, das mit einem (unteren) Halbleitersubstrat, einer oberseitigen Halbleiterschicht und mit einer Vertikal-Isolationsschicht zwischen der Halbleiterschicht und dem Halbleitersubstrat versehen ist. Ferner weisen SOI-Substrate in der Halbleiterschicht ausgebildete Horizontal-Isolationsgräben auf, die sich bis zur Vertikal-Isolationsschicht erstrecken und einzelne Halbleiteraktivgebiete in der Halbleiterschicht elektrisch gegeneinander isolieren.

Damit die in den Halbleiteraktivgebieten ausgebildeten Bauelemente von SOI-Produkten parametrisch korrekt funktionieren, muss das durch die Vertikal-Isolationsschicht von den Halbleiteraktivgebieten isolierte Halbleitersubstrat mit dem niedrigsten Potential verbunden werden. Diesbezüglich ist es beispielsweise bekannt, das Halbleitersubstrat elektrisch mit dem Die-Attach-Feld eines Lead-Frames elektrisch zu verbinden, wobei dann von diesem Die-Attach-Feld über einen sogenannten Downbonddraht einer der Lead-Anschlussfinger kontaktiert wird, so dass der Halbleitersubstratanschluss, wie die übrigen Anschlüsse des SOI-Halbleiterprodukts nach außen geführt ist. Ein Downbond erfordert beim Assemblieren des Halbleiterprodukts zusätzliche Arbeitsschritte, was als aufwendig und nachteilig empfunden wird.

Ferner ist es beispielsweise aus US-A-2002/0094666 bekannt, durch zusätzliche Prozessschritte bei der Ausbildung eines SOI-Halbleiterprodukts in einem Horizontal-Isolationsgraben ein Loch einzubringen, das sich von der Oberseite des SOI-Substrats bis in das untenliegende Halbleitersubstrat erstreckt. Dieses Loch in einem der Horizontal-Isolationsgräben wird dann mit elektrisch leitendem Material gefüllt und dient somit dem oberseitigen Potentialanschluss des untenliegenden Halbleitersubstrats. Das bekannte Verfahren ist wegen des Vorsehens zusätzlicher Prozessschritte relativ aufwendig.

US2009/0057746 zeigt ein weiteres Verfahren, bei dem ein Loch durch die Vertikal-Isolationsschicht bis zum untenliegenden Halbleitersubstrat in einem Halbleiteraktivgebiet hergestellt wird. Dieses Loch wird mit elektrisch leitendem Material gefüllt und dient auch zum oberseitigen Potentialanschluss des untenliegenden Halbleitersubstrats.

Aufgabe der Erfindung ist es, ein SOI-Halbleiterprodukt mit oberseitigem Backgate-Potentialanschluss sowie ein Verfahren zur Herstellung eines derartigen SOI-Halbleiterprodukts zu schaffen, bei denen sich der Backgate-Potentialanschluss oberseitig des SOI-Halbleiterprodukts auf einfache Art und Weise ohne insbesondere zusätzliche Herstellungsprozess- bzw. Assemblierschritte ergibt.

Zur Lösung dieser Aufgabe wird mit der Erfindung ein SOI-Halbleiterprodukt mit oberseitigem Backgate-Potentialanschluss vorgeschlagen, wobei das SOI-Halbleiterprodukt versehen ist mit
- einem SOI-Substrat, das ein unteres Halbleitersubstrat, eine obere Halbleiterschicht und eine Vertikal-Isolationsschicht zwischen der oberen Halbleiterschicht und dem unteren Halbleitersubstrat aufweist,
- mehreren in der oberen Halbleiterschicht ausgebildeten, oberseitigen Halbleiteraktivgebieten zur Ausbildung von HalbleiterbaueLementen, wobei die Halbleiteraktivgebiete durch sich bis zur Vertikal-Isolationsschicht erstreckende Horizontal-Isolationsgräben voneinander getrennt sind, und
- einem Backgate-Potentialanschluss zum Anlegen eines elektrischen Potentials an das Halbleitersubstrat.

Bei diesem SOI-Halbleiterprodukt ist nun erfindungsgemäß vorgesehen,
- dass der Backgate-Potentialanschluss in einem der oberseitigen Halbleiteraktivgebiete angeordnet ist, wobei dieses Halbleiteraktivgebiet ein Backgate-Potentialanschluss-Halbleitergebiet definiert, und
- dass die Vertikal-Isolationsschicht im Bereich unterhalb des Backgate-Potentialanschluss-Halbleitergebiets einen irreversiblen, elektrisch leitenden Durchbruch zur elektrischen Verbindung des Backgate-Potentialanschluss-Halbleitergebiets mit dem Halbleitersubstrat aufweist.

Die zuvor genannte Aufgabe wird erfindungsgemäß ferner mit Hilfe eines Verfahrens zur Herstellung eines oberseitigen Backgate-Potentialanschlusses bei dem zuvor genannten SOI-Produkt gelöst, wobei bei dem Verfahren
- in einem der oberseitigen Halbleiteraktivgebiete ein elektrisch leitendes Backgate-Potentialanschlussgebiet ausgebildet wird und
- zwischen diesem Halbleiteraktivgebiet und dem Halbleitersubstrat eine elektrische Spannung zur Erzeugung eines irreversiblen, elektrisch leitenden Durchbruchs in der Vertikal-Isolationsschicht zur Herstellung einer elektrisch leitenden Verbindung zwischen dem das Backgate-Potentialanschlussgebiet aufweisenden Halbleiteraktivgebiet und dem Halbleitersubstrat angelegt wird.

Die Erfindung ist sinngemäß darin zu sehen, dass unterhalb mindestens eines der Halbleiteraktivgebiete durch die Vertikal-Isolationsschicht hindurch ein irreversibler, elektrisch leitender Durchbruch erzeugt wird, was durch Anlegen einer Durchbruchspannung von mehreren 100 V bis mehreren KV erfolgt. Diese Durchbruchspannung darf nicht zu Horizontaldurchbrüchen zwischen dem Halbleiteraktivgebiet, an das die Spannung angelegt wird, und benachbarten Halbleiteraktivgebieten führen. Dies wird erfindungsgemäß erreicht, indem allseitig des Halbleiteraktivgebiets, an das die Durchbruchspannung zur Erzeugung der elektrischen Verbindung zwischen diesem Halbleiteraktivgebiet und dem untenliegenden Halbleitersubstrat angelegt wird, hoch isolierte Strukturen auf der Wafer-Oberseite bzw. in und auf der oberen Halbleiterschicht des SOI-Substrats erzeugt werden.

Nach der Erfindung wird also an eines der Halbleiteraktivgebiete beispielsweise in dem dem Testen des fertiggestellten SOI-Substrats dienenden Prober ein derart hohes Potential angelegt, dass es zu einem irreversiblen elektrischen Durchschlag in der zum Halbleitersubstrat liegenden Vertikal-Isolationsschicht im SOI-Substrat kommt. Wegen der allseitig hoch isoliert ausgebildeten Struktur der oberen Halbleiterschicht um das besagte, mit dem Hochvolt-Durchschlagpotential beaufschlagte Halbleiteraktivgebiet bildet sich der elektrische Durchschlag nicht horizontal in der Halbleiterschicht sondern vertikal zum Halbleitersubstrat hinaus. Das SOI-Substrat liegt während der Beaufschlagung mit dem Durchschlagpotential zweckmäßigerweise mit seinem Halbleitersubstrat am gleichen Bezugspotential wie die Hochvolt-Durchschlagspannungsquelle. Die hohe Isolation zu den Nachbargebieten innerhalb der oberseitigen Halbleiterschicht erreicht man zweckmäßigerweise durch mehrfache Trenches, Wannen und Widerstände im Layout der oberen Halbleiterschicht. Hierbei ist es zweckmäßig, wenn sich in der oberen Halbleiterschicht um das Backgate-Potentialanschluss-Halbleitergebiet herum mindestens ein Ring-Schutzgebiet erstreckt, das beidseitig Isolationsgräben aufweist und zwischen dem Backgate-Potentialanschluss-Halbleitergebiet und den anderen Halbleiteraktivgebieten der Halbleiterschicht angeordnet ist, wobei insbesondere mindestens eines der Ring-Schutzgebiete ein quer zu Ringerstreckung wirkendes ohmsches Widerstandselement und/oder ein Sperrdiodenelement aufweist und/oder wobei zwischen einem Ring-Schutzgebiet und einem zu diesem benachbarten, durch einen Horizontal-Isolationsgraben getrennten Halbleiteraktivgebiet ein ohmsches Widerstandselement ausgebildet ist.

Die Entstehung des irreversiblen, elektrisch leitenden Durchschlags in der Vertikal-Isolationsschicht erfolgt infolge von getunnelten Elektroden, die in der vertikalen Isolationsschicht einen elektrischen Leitungspfad erzeugt, der bei weiterem Stromfluss Hitzeeinwirkungen auf seine Umgebung innerhalb der Isolationsschicht hat, so dass es zum Schmelzen des Isolationsmaterials und dadurch zur Entstehung eines dauerhaften elektrischen Leiters innerhalb der Isolationsschicht kommt. Der infolge der durch Tunnelung in die Isolationsschicht eindringenden Elektroden fließende Strom wird auch Fowler-Nordheim-Tunnelstrom genannt. Dieser Tunnelstrom und seine Auswirkungen auf insbesondere SiO₂-Isolationsschichten sind grundsätzlich bekannt.

Das Durchbruchpotential bzw. die Durchbruchspannung sollte lediglich kurzzeitig, d.h. gepulst, oder stromkontrolliert angelegt werden, da andernfalls thermische Schäden zu befürchten sind, die die Funktionssicherheit benachbarter Halbleiteraktivgebiete beeinträchtigen können.

Die Erfindung wird nachfolgend unter Bezugnahme auf ein Ausführungsbeispiel sowie anhand der Zeichnung näher erläutert. Im einzelnen zeigen dabei:

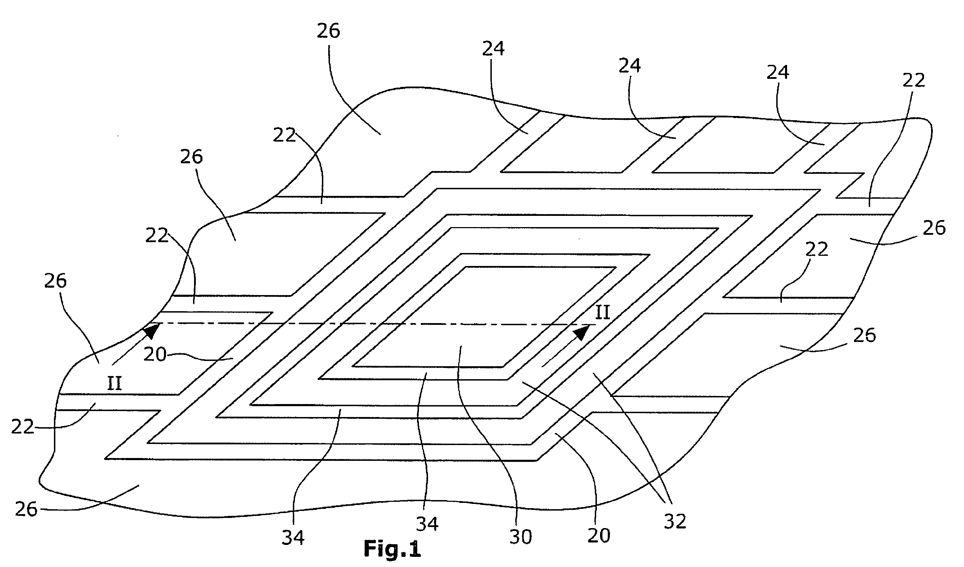

- Fig. 1: perspektivisch eine ausschnittsweise Ansicht auf die Oberseite eines SOI-Substrats mit Darstellung der Verläufe der Horizontal-Isolations- gräben zur elektrischen Isolation benachbarter oberseitigen Halb- leiteraktivgebiete und zur Erzeugung einer hochohmigen Ringstruktur und

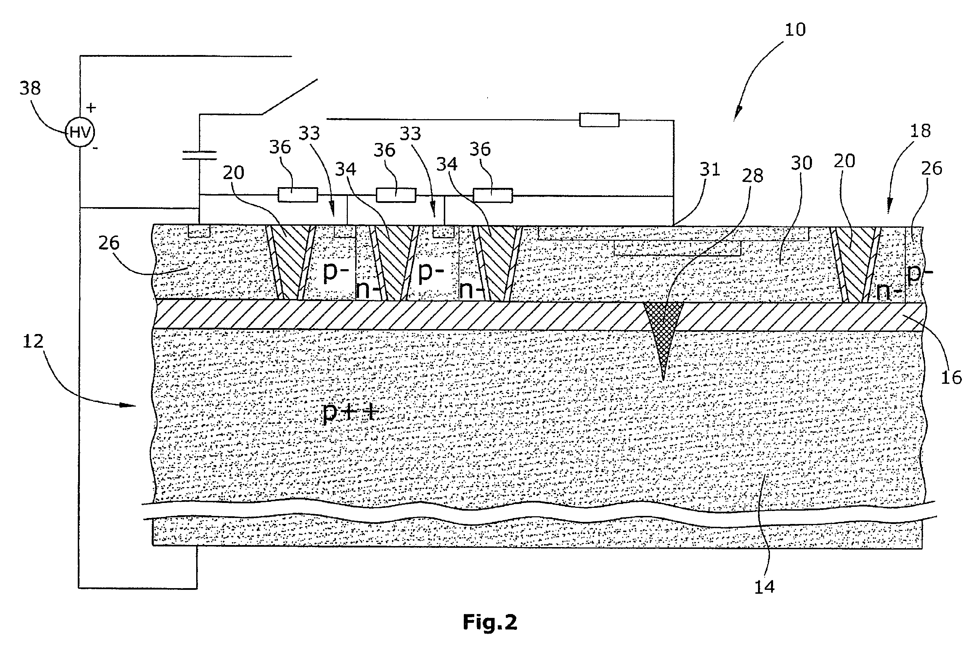

- Fig. 2: einen Schnitt entlang der Linie II-II zur Verdeutlichung des Vertikal- aufbaus des SOI-Substrats und des irreversiblen, elektrischen Durch- schlags durch die Vertikal-Isolationsschicht unterhalb eines der Halb- leiteraktivgebiete, das der oberseitigen Kontaktierung und damit als Backgate-Anschluss des Halbleitersubstrats dient.

In den Fign. 1 und 2 ist schematisch der Aufbau eines SOI-Halbleiterprodukts 10 gezeigt, wobei lediglich die für die Erfindung wesentlichen Elemente des SOI-Halbleiterprodukts 10 schematisch dargestellt sind. Das SOI-Halbleiterprodukt 10 umfasst ein SOI-Substrat 12, das in bekannter Weise ein unteres Halbleitersubstrat 14, eine darüber angeordnete Vertikal-Isolationsschicht 16 und eine oberseitige, auf der Vertikal-Isolationsschicht 16 befindliche Halbleiterschicht 18 umfasst. Die Halbleiterschicht 18 ist durch Horizontal-Isolationsgräben 20,22 und 24 in einzelne gegeneinander elektrisch isolierte Halbleiteraktivgebiete 26 unterteilt, in denen Halbleiterbauelemente ausgebildet sind. Diese Bauelemente sind in den Figuren der Übersichtlichkeit halber nicht dargestellt. Ebenfalls fehlen in den Figuren die Metallisierungsebenen zur elektrischen Verbindung und Kontaktierung der in den Halbleiteraktivgebieten 26 ausgebildeten Bauelemente.

Damit die in den Halbleiteraktivgebieten 26 ausgebildeten Bauelemente des SOI-Halbleiterprodukts 10 parametrisch korrekt funktionieren, muss das Halbleitersubstrat 14 auf dem niedrigsten Potential liegen. Die Kontaktierung des Halbleitersubstrats 14 erfolgt erfindungsgemäß durch eine Kontaktierung über die Halbleiterschicht 18. Zur Entstehung einer elektrischen Verbindung der Halbleiterschicht 18 mit dem gegenüber dieser durch die Vertikal-Isolationsschicht 16 getrennten Halbleitersubstrat 14, wird in der Vertikal-Isolationsschicht 16 ein in Fig. 2 bei 28 angedeuteter irreversibler, elektrisch leitender Durchschlag erzeugt. Hierzu wird in eines der Halbleiteraktivgebiete, nämlich im Halbleiteraktivgebiet 30, ein Potentialanschluss 31 ausgebildet, an den ein Hochvolt-Durchschlagpotential gepulst oder stromkontrolliert angelegt wird. Um zu verhindern, dass das Hochvolt-Durchschlagpotential nicht zu einem horizontalen Durchschlagen der zum Halbleiteraktivgebiet 30 benachbarten Halbleiteraktivgebieten 26 führt (nämlich durch die Horizontal-Isolationsgräben 20 hindurch), ist das dem Durchschlagpotential ausgesetzte Halbleiteraktivgebiet 30 von einer Ringstruktur in Form mehrerer Ringschutzgebiete 32 innerhalb der Halbleiterschicht 18 umgeben, die gegeneinander wiederum durch ebenfalls ringförmige Horizontal-Isolationsgräben 34 getrennt sind. Innerhalb der Ringschutzgebiete 32 weist die Halbleiterschicht 18 als Sperrdiodenelemente 33 fungierende pn-Übergänge auf, wobei zusätzlich die durch die ringförmigen Horizontal-Isolationsgräben 34 und 20 getrennten Ringschutzgebiete durch Widerstandsbahnen o.dgl. im Layout elektrisch verbunden sind.

Diese elektrische Ausbildung der Ringschutzstruktur ist in Fig. 2 gezeigt. Dort sind die elektrischen Widerstände im Layout mit 36 bezeichnet. Durch die elektrische Beschaltung wird nun das hohe Durchschlagpotential, auf dem das Halbleiteraktivgebiet 30 zur Ausbildung des irreversiblen, elektrisch leitenden Durchbruchs 28 liegt, horizontal abgebaut bzw. horizontal elektrisch isoliert, so dass bei der Ausbildung des Durchbruchs 28 die Halbleiterschicht 18 innerhalb der sich an die Ringschutzstruktur angrenzenden Halbleiteraktivgebiete keinen Schaden nimmt. Durch die Isolationsstruktur wird also ein gerichteter Durchschlag vom Halbleiteraktivgebiet 30 zum Halbleitersubstrat 14 erzielt.

In Fig. 2 ist neben der elektrischen Beschaltung, wie sie zum Schutz des SOI-Halbleiterprodukts 10 bei Anlegen des Durchschlagpotentials nötig ist, auch noch schematisch die elektrische Schaltung dargestellt, über die das Halbleiteraktivgebiet 30 und das Substrat 14 an einer Hochvolt-Spannungsquelle 38 anliegt.

## Patentansprüche

1. SOI-Halbleiterprodukt mit
- einem SOI-Substrat (12), das ein unteres Halbleitersubstrat (14), eine obere Halbleiterschicht (18) und eine Vertikal-Isolationsschicht (16) zwischen der oberen Halbleiterschicht (18) und dem unteren Halbleitersubstrat (14) aufweist,
- mehreren in der oberen Halbleiterschicht (18) ausgebildeten, oberseitigen Halbleiteraktivgebieten (26,30) zur Ausbildung von Halbleiterbauelementen, wobei die Halbleiteraktivgebiete (26) durch sich bis zur Vertikal-Isolationsschicht (16) erstreckende Horizontal-Isolationsgräben (20) voneinander getrennt sind, und
- einem Backgate-Potentialanschluss (31) zum Anlegen eines elektrischen Potentials an das Halbleitersubstrat (14),
**dadurch gekennzeichnet ,**
- **dass** der Backgate-Potentialanschluss (31) in einem der oberseitigen Halbleiteraktivgebiete angeordnet ist, wobei dieses Halbleiteraktivgebiet ein Backgate-Potentialanschluss-Halbleitergebiet (30) definiert, und
- **dass** die Vertikal-Isolationsschicht (16) im Bereich unterhalb des Backgate-Potentialanschluss-Halbleitergebiets (30) einen irreversiblen, elektrisch leitenden Durchbruch (28) zur elektrischen Verbindung des Backgate-Potentialanschluss-Halbleitergebiets (30) mit dem Halbleitersubstrat (14) aufweist.

2. SOI-Halbleiterprodukt nach Anspruch 1, **dadurch gekennzeichnet, dass** sich in der oberen Halbleiterschicht (18) um das Backgate-Potentialanschluss-Halbleitergebiet (30) herum mindestens ein Ring-Schutzgebiet (32) erstreckt, das beidseitig Isolationsgräben (34) aufweist und zwischen dem Backgate-Potentialanschluss-Halbleitergebiet (30) und den anderen Halbleiteraktivgebieten (26) der Halbleiterschicht (18) angeordnet ist.

3. SOI-Halbleiterprodukt nach Anspruch 2, **dadurch gekennzeichnet, dass** mindestens eines der Ring-Schutzgebiete ein quer zu Ringerstreckung wirkendes ohmsches Widerstandselement (36) und/oder ein Sperrdiodenelement (33) aufweist.

4. SOI-Halbleiterprodukt nach Anspruch 2 oder 3, **dadurch gekennzeichnet, dass** zwischen einem Ring-Schutzgebiet (32) und einem zu diesem benachbarten, durch einen Horizontal-Isolationsgraben (20) getrennten Halbleiteraktivgebiet (26) ein ohmsches Widerstandselement ausgebildet ist.

5. Verfahren zur Herstellung eines oberseitigen Backgate-Potentialanschlusses bei einem SOI-Produkt, das eine obere Halbleiterschicht (18), ein unteres Halbleitersubstrat (14) und eine zwischen diesen angeordnete Vertikal-Isolationsschicht (16) sowie mehrere zur Ausbildung von Halbleiter-Bauelementen vorgesehene, oberseitige Halbleiteraktivgebiete (26), welche durch sich bis zur Vertikal-Isolationsschicht (16) erstreckende Horizontal-Isolationsgräben (20) getrennt sind, aufweist, wobei bei dem Verfahren
- in einem der oberseitigen Halbleiteraktivgebiete (30) ein elektrisch leitendes Backgate-Potentialanschlussgebiet (31) ausgebildet wird und
- zwischen diesem Halbleiteraktivgebiet und dem Halbleitersubstrat (14) eine elektrische Spannung zur Erzeugung eines irreversiblen, elektrisch leitenden Durchbruchs (28) in der Vertikal-Isolationsschicht (16) zur Herstellung einer elektrisch leitenden Verbindung zwischen dem das Backgate-Potentialanschlussgebiet (31) aufweisenden Halbleiteraktivgebiet (30) und dem Halbleitersubstrat (14) angelegt wird.

6. Verfahren nach Anspruch 5, **dadurch gekennzeichnet, dass** um das das Backgate-Potentialanschlussgebiet (31) aufweisenden Halbleiteraktivgebiet (30) mindestens ein Ring-Schutzgebiet (32) mit beidseitigen Horizontal-Isolationsgräben (34) zur Verhinderung eines Horizontal-Spannungsdurchbruchs durch einen Horizontal-Isolationsgraben bei Anlegen der Spannung zur Erzeugung des irreversiblen Durchbruchs (28) in der Vertikal-Isolationsschicht (16) ausgebildet wird, wobei in bzw. auf dem Ring-Schutzgebiet (32) ein quer zur Ringerstreckung wirkendes ohmsches Widerstandselement und/oder ein Sperrdiodenelement (33) ausgebildet wird.

7. Verfahren nach Anspruch 6, **dadurch gekennzeichnet, dass** das Ring-Schutzgebiet (32) mit seinen benachbarten oberseitigen Halbleiteraktivgebieten (26) elektrisch mittels oberseitig des SOI-Produkts ausgebildeten ohmschen Widerstandselementen (34) verbunden wird.

## Claims

1. SOI semiconductor product comprising
- a SOI substrate (12) comprising a lower semiconductor substrate (14), an upper semiconductor layer (18) and a vertical isolation layer (16) between the upper semiconductor layer (18) and the lower semiconductor substrate (14),
- a plurality of topside semiconductor active regions (26, 30) formed in the upper semiconductor layer (18) for forming semiconductor components, the semiconductor active regions (26) being separated from each other by horizontal isolation trenches (20) extending to the vertical isolation layer (16), and
- a backgate potential connection (31) for applying an electric potential to the semiconductor substrate (14),
**characterized in**
- **that** the backgate potential connection (31) is arranged in one of the topside semiconductor active regions, this semiconductor active region defining a backgate potential connection semiconductor region (30), and
- **that**, in the region below the backgate potential connection semiconductor region (30), the vertical isolation layer (16) comprises an irreversible electrically conductive breakdown path (28) for the electric connection of the backgate potential connection semiconductor region (30) to the semiconductor substrate (14).

2. SOI semiconductor product of claim 1, **characterized in that** at least one annular guard region (32) extends in the upper semiconductor layer (18) around the backgate potential connection semiconductor region (30), which guard region has isolation trenches (34) on both sides and is arranged between the backgate potential connection semiconductor region (30) and the other semiconductor active regions (26) of the semiconductor layer (18).

3. SOI semiconductor product of claim 2, **characterized in that** at least one of the annular guard regions comprises an ohmic resistor element (36), acting transversely to the extension of the annulus, and/or a blocking diode element (33).

4. SOI semiconductor product of claim 2 or 3, **characterized in that** an ohmic resistor element is formed between an annular guard region (32) and a semiconductor active region (26) adjacent thereto and separated therefrom by a horizontal isolation trench (20).

5. Method for producing a topside backgate potential connection in a SOI product comprising an upper semiconductor layer (18), a lower semiconductor substrate (14) and a vertical isolation layer (16) arranged therebetween, as well as a plurality of topside semiconductor active regions (26) for forming semiconductor components, the semiconductor active regions being separated from each other by horizontal isolation trenches (20) extending to the vertical isolation layer (16), wherein in the method
- an electrically conductive backgate potential connection region (31) is formed in one of the topside semiconductor active regions (30), and
- an electric voltage is applied between this semiconductor active region and the semiconductor substrate (14) to generate an irreversible electrically conductive breakdown path (28) in the vertical isolation layer (16) so as to form an electrically conductive connection between the semiconductor active region (30) comprising the backgate potential connection region (31) and the semiconductor substrate (14).

6. Method of claim 5, **characterized in that** at least one annular guard region (32) with horizontal isolation trenches (34) on both sides is formed around the semiconductor active region (30) comprising the backgate potential connection region (31) in order to prevent a horizontal voltage breakdown through a horizontal isolation trench when the voltage is applied to create the irreversible breakdown path (28) in the vertical isolation layer (16), an ohmic resistor element acting transversely to the extension of the annulus and/or a blocking diode element (33) is formed in or on the annular guard region (32).

7. Method of claim 6, **characterized in that** the annular guard region (32) is electrically connected to its adjacent topside semiconductor active regions (26) through ohmic resistor elements (34) formed on the top of the SOI product.

## Revendications

1. Produit semi-conducteur SOI comprenant
- un substrat SOI (12) avec un substrat semi-conducteur (14) bas, une couche semi-conductrice (18) haute, et une couche d'isolation verticale (16) entre ladite couche semi-conductrice (18) haute et ledit substrat semi-conducteur (14) bas,
- plusieurs régions actives semi-conductrices (26, 30) côté supérieur formées dans ladite couche semi-conductrice (18) haute pour former des éléments semi-conducteurs, lesdites régions actives semi-conductrices (26) étant séparées par des rainures d'isolation horizontales (20) s'étendant jusqu'à ladite couche d'isolation verticale (16), et
- un raccordement de potentiel de grille arrière (31) pour appliquer un potentiel électrique au substrat semi-conducteur (14),
**caractérisé en ce**
- **que** ledit raccordement de potentiel de grille arrière (31) est disposé dans une des régions actives semi-conductrices côté supérieur, cette région active semi-conductrice définissant une région semi-conductrice de raccordement de potentiel de grille arrière (30), et
- **que**, dans la région sous la région semi-conductrice de raccordement de potentiel de grille arrière (30), ladite couche d'isolation verticale (16) comprend une voie de percée (28) irréversible, électriquement conductrice, pour raccorder électriquement ladite région semi-conductrice de raccordement de potentiel de grille arrière (30) au substrat semi-conducteur (14).

2. Produit semi-conducteur SOI selon la revendication 1, **caractérisé en ce qu'**au moins une zone protectrice annulaire (32) s'étend dans ladite couche semi-conductrice (18) haute autour de région semi-conductrice de raccordement de potentiel de grille arrière (30), ladite zone comprenant des rainures d'isolation (34) de part et d'autre de la zone et étant disposée entre ladite région semi-conductrice de raccordement de potentiel de grille arrière (30) et les autres régions actives semi-conductrices (26) de ladite couche semi-conductrice (18).

3. Produit semi-conducteur SOI selon la revendication 2, **caractérisé en ce qu'**au moins une des zones protectrices annulaires comprend un élément de résistance ohmique (36), effectif dans le sens transversal à l'extension de l'anneau, et/ou un élément de diode de blocage (33).

4. Produit semi-conducteur SOI selon les revendications 2 ou 3, **caractérisé en ce qu'**un élément de résistance ohmique est formé entre une zone protectrice annulaire (32) et une région active semi-conductrice (26) voisine à ladite zone et séparée d'elle par une rainure d'isolation horizontale (20).

5. Procédé de fabrication d'un raccordement de potentiel de grille arrière, côté supérieur, dans un produit SOI comprenant une couche semi-conductrice (18) haute, un substrat semi-conducteur (14) bas et une couche d'isolation verticale (16) disposée entre ceux-ci, et plusieurs régions actives semi-conductrices (26) côté supérieur pour former des éléments semi-conducteurs, lesdites régions étant séparées par des rainures d'isolation horizontales (20) s'étendant jusqu'à ladite couche d'isolation verticale (16), ledit procédé comprenant les étapes suivantes:
- former une région de raccordement de potentiel de grille arrière (31) dans une des régions actives semi-conductrices (30) côté supérieur, la région de raccordement étant électriquement conductrice, et
- appliquer une tension électrique entre ladite région active semi-conductrice et ledit substrat semi-conducteur (14) pour générer une voie de percée (28) irréversible, électriquement conductrice, dans ladite couche d'isolation verticale (16) afin d'établir une connexion électriquement conductrice entre ladite région active semi-conductrice (30) comprenant la région de raccordement de potentiel de grille arrière (31) et ledit substrat semi-conducteur (14).

6. Procédé selon la revendication 5, **caractérisé en ce qu'**au moins une zone protectrice annulaire (32) avec rainures d'isolation (34) horizontale de part et d'autre est formée autour de ladite région active semi-conductrice (30) comprenant la région de raccordement de potentiel de grille arrière (31), pour empêcher une claquage horizontale de tension à travers une rainure d'isolation horizontal lors de l'application de la tension destinée à la formation de ladite voie de percée (28) irréversible dans ladite couche d'isolation verticale (16), un élément de résistance ohmique, effectif dans le sens transversal à l'extension de l'anneau, et/ou un élément de diode de blocage (33) étant formé dans ou sur ladite zone protectrice annulaire (32).

7. Procédé selon la revendication 6, **caractérisé en ce que** ladite zone protectrice annulaire (32) est connectée électriquement à ses régions actives semi-conductrices (26) voisines, côté supérieur, par des éléments de résistance ohmique (34) formés sur la face supérieure dudit produit SOI.
